# EUROPEAN PATENT APPLICATION

(11) **EP 4 723 119 A1**
(43) Date of publication of application: **08.04.2026**
(21) Application number: 24930391.8
(22) Date of filing: 27.09.2024
(51) Int. Cl.: G11C 16/08, G11C 16/24, G11C 16/26

(54) **SENSE AMPLIFIER AND SENSING METHOD THEREOF, STORAGE DEVICE AND DATA READING METHOD THEREFOR, AND ELECTRONIC DEVICE**

(30) Priority: 20.03.2024 CN 202410317884
(71) Applicant: Beijing Superstring Academy of Memory Technology, Beijing 100176 (CN)
(72) Inventor: DAI, Jin, Beijing 100176 (CN)
(74) Representative: Gulde & Partner
(86) International application number: PCT/CN2024/121782
(87) International publication number: WO 2025/194732

(57) **Abstract**

The present disclosure relates to a sense amplifier and a sensing method thereof, a storage device and a data reading method therefor, and an electronic device. The sense amplifier (1) is configured to be connected to a bit line (BL) to read data stored in a storage unit (U). The sense amplifier (1) comprises a charge integrator (11) and a secondary amplifier (12). The charge integrator (11) is correspondingly connected to the storage unit (U) by means of the bit line (BL), and is configured to: measure the total amount of charge flowing into or out of the bit line (BL) under a stable bit line (BL) voltage, and convert the total amount of charge into a voltage as an initial read signal. The secondary amplifier (12) is connected to an output end of the charge integrator (11) and is configured to: compare the initial read signal with a reference signal so as to output a data read signal on the basis of a comparison result between the initial read signal and the reference signal.

## Description

### CROSS REFERENCE TO RELATED APPLICATIONS

This disclosure claims priority of Chinese patent application No. 202410317884.7 filed in the China Patent Office on March 20, 2024 and entitled "SENSE AMPLIFIER AND SENSING METHOD THEREOF, STORAGE DEVICE AND DATA READING METHOD THEREFOR, AND ELECTRONIC DEVICE", entirety of which is incorporated herein by reference.

### TECHNICAL FIELD

The present disclosure relates to the technical field of semiconductors, in particular to a sense amplifier and a sensing method thereof, a storage device and a data reading method thereof, and an electronic device.

### BACKGROUND

With development of communication technology and digital technology, people continue to pursue products with lower power consumption, lighter weight and better performance. A storage device such as a random access memory (RAM), a disk and a flash memory (Flash), as a memory device that may store information, has been widely used in electronic devices. However, performance of a sense amplifier, as one of important components of the storage device, easily affects performance of the storage device.

### SUMMARY

According to some embodiments, a sense amplifier is provided in an aspect of the present disclosure, which is configured to be connected with a bit line to read data stored in a memory cell. The sense amplifier includes a charge integrator and a secondary amplifier. The charge integrator is correspondingly connected with the memory cell through the bit line, and is configured to measure a total amount of charge flowing into or out of the bit line at a stable bit line voltage, and convert the total amount of charge into a voltage as an initial read signal. The secondary amplifier is connected with an output terminal of the charge integrator and is configured to compare the initial read signal with a reference signal to output a data read signal according to a comparison result of the initial read signal and the reference signal.

According to some embodiments, the sense amplifier further includes a pre-charge circuit. The pre-charge circuit is configured to be connected with the charge integrator to pre-charge the charge integrator at an initialization stage, and to be disconnected from the charge integrator at a data reading stage. The bit line is precharged to a first reference voltage or a second reference voltage at the initialization stage.

According to some embodiments, the charge integrator includes an operational amplifier and a feedback capacitor. The operational amplifier has a first input terminal, a second input terminal and an output terminal. The first input terminal is configured to receive a first preset voltage. The second input terminal is connected with the bit line and is configured to be precharged to a second preset voltage and receive the charge transferred from the bit line at the data reading stage. The output terminal is configured to output the initial read signal at the data reading stage. The feedback capacitor has a first electrode and a second electrode. The first electrode of the feedback capacitor is connected with the second input terminal of the operational amplifier, and the second electrode of the feedback capacitor is connected with the output terminal of the operational amplifier.

According to some embodiments, the reference signal is a voltage threshold; and/or the second preset voltage is equal to the first preset voltage.

According to some embodiments, the secondary amplifier includes a latch amplifier.

According to some embodiments, a sensing method of a sense amplifier is further provided in another aspect of the present disclosure, which includes: at a data reading stage, measuring a total amount of charge flowing into or out of a bit line at a stable bit line voltage and converting the total amount of charge into a voltage as an initial read signal by a charge integrator; comparing the initial read signal with a reference signal and outputting a data read signal according to a comparison result of the initial read signal and the reference signal by a secondary amplifier. The charge integrator is correspondingly connected with a memory cell through a bit line, and the data read signal is configured to characterize data stored in the memory cell.

According to some embodiments, the sensing method of the sense amplifier further includes: at an initialization stage, precharging the bit line while initializing the charge integrator. The initialization stage is performed before the data reading stage.

According to some embodiments, at the data reading stage, before measuring the total amount of charge flowing into or out of the bit line at the stable bit line voltage and converting the total amount of charge into the voltage as the initial read signal by the charge integrator, the sensing method of the sense amplifier further includes: disconnecting a pre-charge circuit from the charge integrator.

According to some embodiments, a storage device is further provided in a yet another aspect of the present disclosure, which includes a memory cell, a bit line, and a sense amplifier as described in any of above embodiments. The memory cell is configured to store data. The bit line is connected with the memory cell. The sense amplifier is connected with the bit line and is configured to read data stored in the memory cell through the bit line.

According to some embodiments, the storage device further includes a gate transistor. The gate transistor is connected with the bit line and the charge integrator in the sense amplifier, and is configured to control the bit line to be electrically connected with the charge integrator in the sense amplifier at the data reading stage in response to a column scanning signal for charge transfer.

According to some embodiments, the memory cell includes a transistor and a capacitor. A first source/drain of the transistor is connected with the bit line, a second source/drain of the transistor is connected with a first electrode of the capacitor, and a second electrode of the capacitor is grounded. The storage device further includes a word line connected with a gate of the transistor.

Accordingly, according to some embodiments, a data reading method of the storage device above includes:
precharging a voltage of the bit line connected with the memory cell to a first reference voltage or a second reference voltage, while initializing the charge integrator in the sense amplifier, the first reference voltage being greater than the second reference voltage and difference between the first reference voltage and the second reference voltage satisfying a first preset value;
providing a third reference voltage to the word line connected with the memory cell; and
outputting, by the sense amplifier, a data read signal according to whether the charge on the bit line is transferred or not, the data read signal being configured to characterize data stored in the capacitor of the memory cell.

According to some embodiments, the first reference voltage is a highest voltage in a pre-charge voltage range of the bit line, and the second reference voltage is a lowest voltage in the pre-charge voltage range of the bit line.

According to some embodiments, the memory cell includes a transistor and a first ferroelectric capacitor. A first source/drain of the transistor is connected with the bit line, a second source/drain of the transistor is connected with a first electrode of the first ferroelectric capacitor, and a second electrode of the first ferroelectric capacitor is grounded. The storage device further includes a word line connected with a gate of the transistor.

Accordingly, according to some embodiments, a data reading method of the storage device above includes:
precharging a voltage of the bit line connected with the memory cell to a first reference voltage while initializing the charge integrator in the sense amplifier;
providing a fourth reference voltage to the word line connected with the memory cell; and
outputting, by the sense amplifier, a data read signal according to whether the charge on the bit line is transferred or not, the data read signal being configured to characterize data stored in the first ferroelectric capacitor of the memory cell.

According to some embodiments, the memory cell includes a second ferroelectric capacitor. A first electrode of the second ferroelectric capacitor is connected with the bit line. The storage device further includes a word line connected with a second electrode of the second ferroelectric capacitor.

Accordingly, according to some embodiments, a data reading method of the storage device above includes:
precharging a voltage of the bit line connected with the memory cell to a first reference voltage and providing a fifth reference voltage to the word line connected with the memory cell, while initializing the charge integrator in the sense amplifier;
providing a sixth reference voltage to the word line connected with the memory cell, the fifth reference voltage being greater than the sixth reference voltage, and difference between the fifth reference voltage and the sixth reference voltage satisfying a second preset value; and
outputting, by the sense amplifier, a data read signal according to whether the charge on the bit line is transferred or not, the data read signal being configured to characterize data stored in the second ferroelectric capacitor of the memory cell.

According to some embodiments, the first reference voltage is a highest voltage in a pre-charge voltage range of the bit line, the fifth reference voltage is a highest voltage in a configurable voltage range of the word line, and the sixth reference voltage is a lowest voltage in the configurable voltage range of the word line.

According to some embodiments, if the charge on the bit line is transferred, after the sense amplifier outputs the data read signal, the data reading method further includes performing a recovery write operation on the memory cell to recover the read data in the memory cell.

According to some embodiments, an electronic device is further provided in another aspect of the present disclosure, including the storage device as described in some embodiments above.

Details of one or more embodiments of the present disclosure are set forth in the following drawings and description. Other features, objects and advantages of the present disclosure become apparent from the description, drawings and claims.

### BRIEF DESCRIPTION OF THE DRAWINGS

In order to explain technical solutions in the embodiments of the present disclosure more clearly, the drawings required in the description of the embodiments will be briefly introduced below; obviously, the drawings in the following description are only some embodiments of the present disclosure, and drawings of other embodiments may be obtained according to these drawings by those of ordinary skilled in the art without paying creative labor.
FIG. 1 is a schematic structural view of a sense amplifier and a storage device provided in some embodiments of the present disclosure;
FIG. 2 is a schematic structural view of a charge integrator provided in some embodiments of the present disclosure;
FIG. 3 is a flowchart of a sensing method of a sense amplifier provided in some embodiments of the present disclosure;
FIG. 4 is a flowchart of another sensing method of the sense amplifier provided in some embodiments of the present disclosure;
FIG. 5 is a schematic structural view of a storage device provided in some embodiments of the present disclosure;
FIG. 6 is a flowchart of a data reading method of a storage device shown in FIG. 5;
FIG. 7 is a schematic structural view of another storage device provided in some embodiments of the present disclosure;
FIG. 8 is a flowchart of a data reading method of a storage device shown in FIG. 7;
FIG. 9 is a schematic structural view of yet another storage device provided in some embodiments of the present disclosure; and
FIG. 10 is a flowchart of a data reading method of a storage device shown in FIG. 9.

### DETAILED DESCRIPTION

In order to facilitate understanding of the present disclosure, the present disclosure will be described more fully below with reference to relevant drawings. Embodiments of the present disclosure are shown in the accompanying drawings. However, the present disclosure may be implemented in many different forms and is not limited to embodiments described herein. On the contrary, these embodiments are provided to make the present disclosure more thorough and comprehensive.

Unless otherwise defined, all technical and scientific terms used herein have same meaning as commonly understood by those skilled in the art of the present disclosure. Terminology used in description of the present disclosure herein is only for a purpose of describing specific embodiments, and is not intended to limit the present disclosure.

Reference to "embodiment" herein means that a particular feature, structure or characteristic described in combination with the embodiment may be included in at least one of embodiments of the present disclosure. Occurrence of the phrase in various parts in the specification does not necessarily refer to a same embodiment, nor is it an independent or alternative embodiment mutually exclusive with other embodiments. It is understood explicitly and implicitly by those skilled in the art that the embodiments described herein may be combined with other embodiments.

It may be understood that terms such as "first", "second", "third" and "fourth" used in this disclosure may be used to describe various elements herein, but these elements are not limited by these terms. These terms are only used to distinguish the first element from another element. For example, without departing from the scope of this disclosure, a first transistor may be called a second transistor, and similarly, the second transistor may be called the first transistor. Both the first transistor and the second transistor are transistors, but not a same transistor.

It may be understood that "connected" in following embodiments should be understood as "electrically connected" or "communicatively connected" or the like if there is transmission of electrical signals or data between connected circuits, modules, units and the like.

When used herein, singular forms of "a", "an" and "said/the" may also include plural forms, unless otherwise indicated clearly in the context. It should also be understood that terms "including/comprising" or "having" and the like specify existence of stated features, integers, steps, operations, components, parts or combinations thereof, but do not exclude possibility of presence or addition of one or more other features, integers, steps, operations, components, parts or combinations thereof. Meanwhile, a term "and/or" used in this specification includes any and all combinations of relevant listed items.

A semiconductor storage device is a storage device implemented based on a semiconductor material such as silicon (Si), germanium (Ge), gallium arsenide (GaAs) or indium phosphide (InP) or the like. Semiconductor storage devices may be mainly divided into volatile storage devices and nonvolatile storage devices. The volatile storage device is a storage device where data stored therein may be lost when a power supply is turned off. The volatile storage device includes, for example, a static random access memory (SRAM), a dynamic random access memory (DRAM) and a synchronous dynamic random access memory (SDRAM). The nonvolatile storage device is a storage device where the data stored therein may be kept even when the power supply is turned off. The nonvolatile storage device includes, for example, a read-only memory (ROM), a programmable read-only memory (PROM), an electrically programmable read-only memory (EPROM), an electrically erasable programmable read-only memory (EEPROM), a NAND flash memory, a NOR flash memory, a phase-change random access memory (PRAM), a magnetic random access memory (MRAM), a resistive random access memory (RRAM), a ferroelectric random access memory (FRAM) and the like.

However, in related art, sense amplifiers of various types of storage device serve to sense based on voltage detection. For example, a memory cell array is connected to a bit line and a complementary bit line, and when a read operation or a refresh operation is performed, a sense amplifier senses and amplifies voltage difference between the bit line and the complementary bit line. During the read operation or refresh operation, the bit line is floated, and change in charge caused by selection of a memory cell may be shared by the parasitic capacitors on related circuits such as the bit line and peripheral circuits, which is easy to cause large attenuation of a read signal.

On this basis, a sense amplifier and a sensing method thereof, a storage device and a data reading method thereof, and an electronic device are provided in embodiments of the present disclosure, which may effectively eliminate signal attenuation caused by parasitic capacitors on a bit line, so as to improve accuracy in reading stored data, thereby improving performance of the sense amplifier, the storage device, and the electronic device.

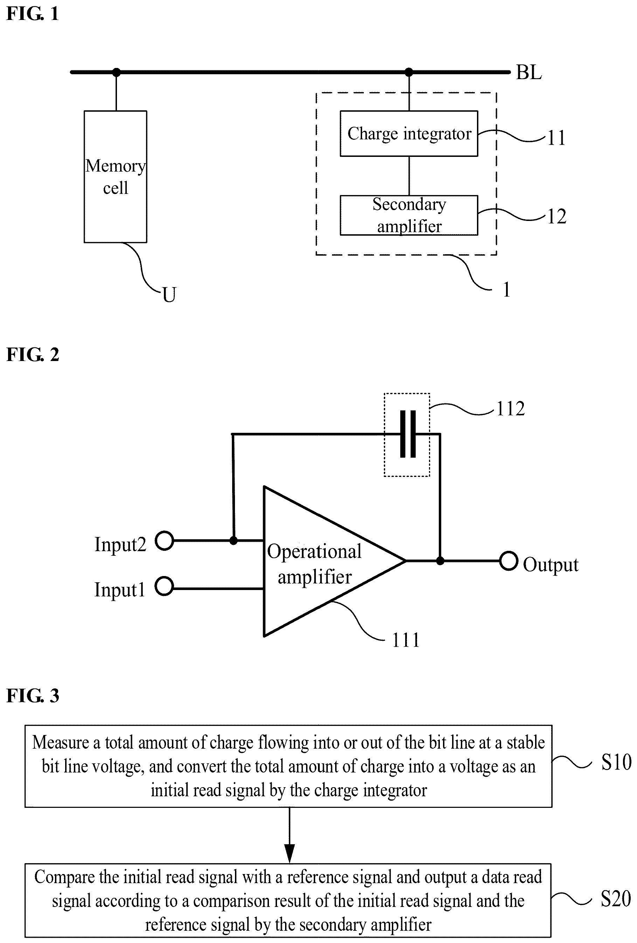

Referring to FIG. 1, in some embodiments of the present disclosure, a sense amplifier 1 is configured to be connected with a bit line BL to read data stored in a memory cell U. The sense amplifier 1 includes a charge integrator 11 and a secondary amplifier 12. The charge integrator 11 is correspondingly connected with the memory cell U through the bit line BL, and is configured to measure a total amount of charge flowing into or out of the bit line BL at a stable bit line voltage, and convert the total amount of charge into a voltage as an initial read signal. The secondary amplifier 12 is connected with an output terminal of the charge integrator 11 and is configured to compare the initial read signal with a reference signal to output a data read signal according to a comparison result of the initial read signal and the reference signal. The data read signal is configured to characterize the data stored in the memory cell U.

It may be understood that data that the memory cell U may store includes, for example, data "0" and data "1". In addition, the data "1" and data "0" may be stored in different ways according to a structure of the memory cell U. For example, in a DRAM, the data "1" and data "0" may be characterized by different data voltages written into the memory cell U, where a data voltage corresponding to the data "1" and a data voltage corresponding to the data "0" may be both positive or negative voltages, or may be voltages with opposite polarities. Alternatively, for example, in a FRAM, the data "1" and the data "0" may be characterized by different polarization states of the memory cell U. Therefore, at a data reading stage, after the memory cell U is selected, a memory cell U that stores the data "1" or a memory cell U that stores the data "0" may generate easily distinguishable charge changes based on its data voltage or its polarization state.

For example, a gate transistor is connected between the charge integrator 11 and the bit line BL. The gate transistor may control the bit line BL to be connected with the charge integrator 11 at the data reading stage in response to a column scanning signal for charge transfer.

In the embodiment of the present disclosure, the charge integrator 11 and the secondary amplifier 12 are arranged in the sense amplifier 1, and the charge integrator 11 may be used to sense charge change on the bit line BL at the data reading stage. Specifically, the charge integrator may measure a total amount of charge flowing into or out of the bit line at a stable bit line voltage, and convert the total amount of charge into a voltage as an initial read signal, so that after the charge integrator 11 outputs the initial read signal according to the charge change, the secondary amplifier 12 may be used to output the data read signal according to the comparison result between the initial read signal and the reference signal, so as to read out data stored in the memory cell U. Due to the above data reading process of the embodiment of the present disclosure, there is no need to float the bit line BL during the data reading stage, which may prevent the charge change generated by the memory cell U from being shared by the parasitic capacitors on related circuits such as the bit line BL and peripheral circuits (that is, the parasitic capacitors on a reading path of the memory cell U do not draw or discharge charges), and thus do not cause too large voltage change on the bit line BL connected with the charge integrator 11 and the whole reading path of the memory cell U, and may effectively avoid large attenuation of a signal, thus facilitating improving of accuracy in reading stored data and improving performance of the sense amplifier, the storage device, and the electronic device.

In some embodiments, which may be understood with reference to FIGS. 1 and 2, the charge integrator 11 includes an operational amplifier 111 and a feedback capacitor 112. The operational amplifier 111 has a first input terminal Input1, a second input terminal Input2 and an output terminal Output. The first input terminal Input1 is configured to receive a first preset voltage. The second input terminal Input2 is connected with the bit line BL and is configured to be precharged to a second preset voltage and receive the charge transferred from the bit line BL at the data reading stage. The output terminal Output is configured to output the initial read signal at the data reading stage. The feedback capacitor 112 has a first electrode and a second electrode. The first electrode of the feedback capacitor 112 is connected with the second input terminal Input2 of the operational amplifier 111, and the second electrode of the feedback capacitor 112 is connected with the output terminal Output of the operational amplifier 111.

For example, the second input terminal Input2 is connected with the bit line BL through the gate transistor.

For example, the second preset voltage is equal to the first preset voltage. That is, the second preset voltage of the precharged second input terminal Input2 is the same as the first preset voltage received by the first input terminal Input1, and an operation of the operational amplifier 111 may basically lock a voltage of the second input terminal Input2 to this preset voltage.

In some embodiments, the sense amplifier 1 further includes a pre-charge circuit (not shown in FIG. 1). The pre-charge circuit is configured to be connected with the charge integrator 11 to precharge the charge integrator 11 at an initialization stage, and to be disconnected from the charge integrator 11 at the data reading stage. The bit line BL is precharged to the first reference voltage or the second reference voltage at the initialization stage.

Here, according to applications of the sense amplifier 1 in different storage device, pre-charge voltages of the bit line BL at the initialization stage may be the same or different, which may be specifically understood in combination with related description in the data reading method of the storage device below.

For example, referring to FIG. 2, an initialization signal of the charge integrator 11 is a pre-charge signal. The first input terminal Input1 and the second input terminal Input2 of the operational amplifier 111 may be connected with respective pre-charge circuits (not shown in FIG. 2), and the pre-charge circuits are configured to precharge the operational amplifier 111 to initialize the operational amplifier 111 at the initialization stage, and to be disconnected from the operational amplifier 111 at the data reading stage. In the embodiments of the present disclosure, circuit design of the pre-charge circuit is not specifically limited, so long as functions described above may be realized. Optionally, the pre-charge circuit may be a switching device or other circuit structure connected with a power supply voltage terminal, which is configured to provide a rated high-level voltage.

In some embodiments, the secondary amplifier includes, but is not limited to, a latch amplifier. Circuit design of the secondary amplifier may be made to effectively output the data read signal according to the comparison result of the initial read signal and the reference signal after comparing the initial read signal with the reference signal.

It should be added that in some embodiments, the initial read signal is a voltage signal. Accordingly, the reference signal for comparison with the initial read signal in the secondary amplifier may adopt a voltage threshold. In this way, it is convenient for the secondary amplifier to convert the initial read signal into a high level that may characterize data "1" or a low level that may characterize data "0" according to whether a voltage of the initial read signal exceeds a set voltage threshold, so as to simplify the circuit design of the secondary amplifier.

A sensing method of a sense amplifier is further provided in some embodiments of the present disclosure, which may be applied to the sense amplifier in some embodiments above. The sensing method of the sense amplifier also have technical advantages of the sense amplifier described above, which will not be described here again.

Referring to FIG. 3, a reading cycle of the sense amplifier includes a data reading stage. The sensing method of the sense amplifier includes step S10 and step S20 performed at the data reading stage.

In S10, the charge integrator measures a total amount of charge flowing into or out of the bit line at a stable bit line voltage, and converts the total amount of charge into a voltage as an initial read signal.

In S20, the secondary amplifier compares the initial read signal with a reference signal and outputs a data read signal according to a comparison result of the initial read signal and the reference signal.

Here, the charge integrator is correspondingly connected with the memory cell through the bit line, and the data read signal may be used to characterize data stored in the memory cell.

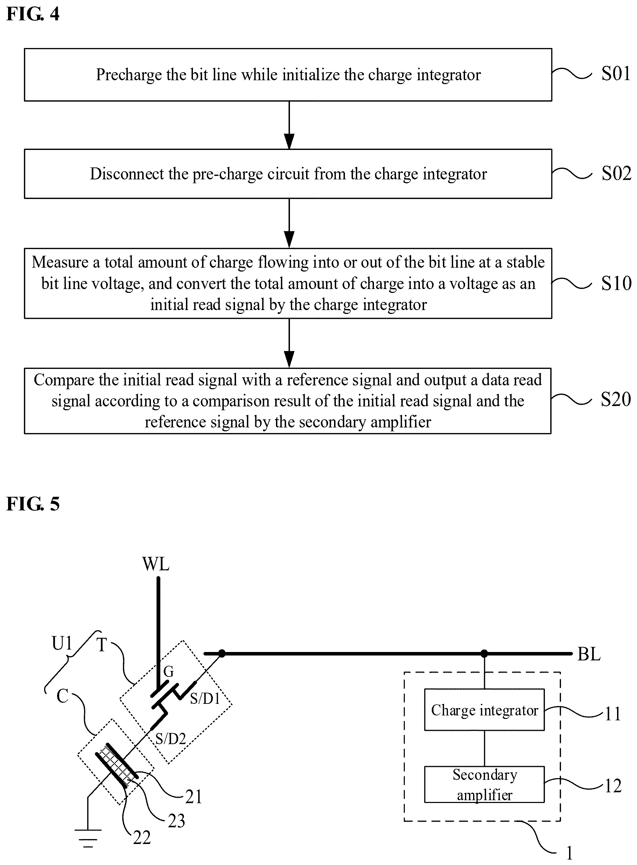

In some embodiments, referring to FIG. 4, the reading cycle of the sense amplifier further includes an initialization stage. The initialization stage is before the data reading stage. The sensing method of the sense amplifier further includes step S01 performed in the initialization stage.

In S01, the bit line is precharged while the charge integrator is initialized.

For example, the bit line may be precharged to a first reference voltage or a second reference voltage.

For example, an initialization signal of the charge integrator is a pre-charge signal, and initialization of the charge integrator may be realized by a pre-charge circuit correspondingly connected with the charge integrator.

Accordingly, in some embodiments, with further reference to FIG. 4, the sensing method of the sense amplifier further includes step S02 performed at the data reading stage, and the step S02 is performed before the step S10.

In S02, the pre-charge circuit is disconnected from the charge integrator.

A storage device is further provided in some embodiments of the present disclosure, which includes, but is not limited to, various types of semiconductor storage device described above.

For example, with reference to FIGS. 1, 5, 7 and 9, the storage device includes a memory cell U, a bit line BL and the sense amplifier 1 as described in any of the embodiments above. The memory cell U is configured to store data. The bit line BL is connected with the memory cell U. The sense amplifier 1 is connected with the bit line BL and is configured to read data stored in the memory cell U through the bit line BL.

For example, a gate transistor is connected between the sense amplifier 1 and the bit line BL.

The gate transistor may control the bit line BL to be connected with the charge integrator 11 at the data reading stage in response to a column scanning signal for charge transfer.

It may be understood that a storage device generally includes a plurality of memory cells U, which may be distributed two-dimensionally in a single layer or three-dimensionally in multiple layers. For convenience of description and understanding, the storage device described in FIGS. 5, 7 and 9 is illustrated by taking one memory cell U and a sense amplifier 1 connected with this one memory cell U as an example. Moreover, in describing the storage device provided in the embodiment of the present disclosure, the embodiment of the present disclosure mainly focuses on the memory cell U and the sense amplifier 1 connected to the memory cell U, and does not involve peripheral circuits (such as a row addressing driving circuit, a column addressing driving circuit, etc.) and related circuits in the storage device.

It may be understood that data that the memory cell U may store includes, for example, data "0" and data "1". And, the data "1" and data "0" may be stored in different ways according to a structure of the memory cell U.

In some examples, the storage device is a DRAM, for example. For example, the data "1" and data "0" may be characterized by different data voltages written into the memory cell U, where a data voltage corresponding to the data "1" and a data voltage corresponding to the data "0" may be both positive or negative voltages, or may be voltages with opposite polarities.

In other examples, the storage device is a FRAM, for example. In the FRAM, the data "1" and the data "0" may be characterized by different polarization states of the memory cell U.

Therefore, at the data reading stage, after the memory cell U is selected, a memory cell U that stores the data "1" or a memory cell U that stores the data "0" may generate easily distinguishable charge changes based on its data voltage or its polarization state.

Following embodiments of the present disclosure exemplify possible implementations of the memory cells U in some different storage devices.

In some embodiments, referring to FIG. 5, the storage device is a DRAM, for example. The memory cell U is a one-transistor one-capacitor (1T1C) memory cell U1, which includes a transistor T and a capacitor C. A first source/drain S/D1 of the transistor T is connected with the bit line BL, for example, the first source/drain S/D1 of the transistor T is connected with the bit line BL through a gate transistor. A second source/drain electrode S/D2 of the transistor T is connected with a first electrode 21 of the capacitor C, and a second electrode 22 of the capacitor C is grounded. The storage device further includes a word line WL connected with a gate G of the transistor T.

Here, one of the first source/drain S/D1 and the second source/drain S/D2 of the transistor T may be a source and the other of the first source/drain S/D1 and the second source/drain S/D2 of the transistor T may be a drain, according to a current transmission direction. The capacitor C is an ordinary capacitor, that is, a dielectric layer 23 between the first electrode 21 and the second electrode 22 in the capacitor C is of an insulating material.

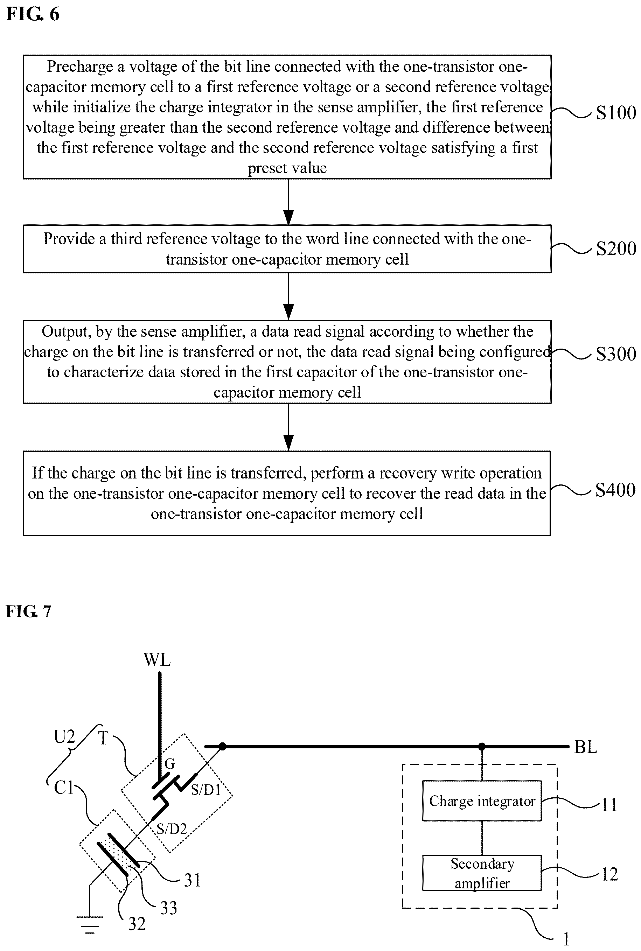

Accordingly, in some embodiments, referring to FIG. 6, a data reading method of the storage device includes following steps S100 to S300.

In S100, a voltage of the bit line connected with the one-transistor one-capacitor memory cell is precharged to a first reference voltage or a second reference voltage while the charge integrator in the sense amplifier is initialized, wherein the first reference voltage is greater than the second reference voltage and difference between the first reference voltage and the second reference voltage satisfies a first preset value.

In S200, a third reference voltage is provided to a word line connected with the one-transistor one-capacitor memory cell.

In S300, the sense amplifier outputs a data read signal according to whether charge on the bit line is transferred or not, wherein the data read signal is configured to characterize data stored in the first capacitor of the one-transistor one-capacitor memory cell.

Here, a process of obtaining the data read signal by the sense amplifier may be carried out with reference to a related flow of the sensing method of the sense amplifier. The data reading method of the storage device also has the technical advantages of the sensing method of the sense amplifier, which will not be described here again.

It may be understood that the first reference voltage, the second reference voltage and the third reference voltage described above may all be set according to requirements.

For example, the first reference voltage may be a highest voltage in a pre-charge voltage range of the bit line, and the second reference voltage may be a lowest voltage in the pre-charge voltage range of the bit line.

For example, the third reference voltage may control the transistor T in the one-transistor one-capacitor memory cell U1 to turn on. At this time, the first electrode 21 of the capacitor C may change in the charge, and the changed charge may be transferred to the charge integrator 11 through the turned-on transistor T and the bit line BL, so that the charge integrator 11 may output a corresponding voltage signal as the initial read signal. Afterwards, the secondary amplifier 12 in the sense amplifier 1 may output the data read signal according to the comparison result of the initial read signal and the reference signal by comparing the initial read signal with the reference signal.

For example, the reference signal is a voltage threshold, for example. The secondary amplifier 12 may convert the initial read signal into a high level that may characterize data "1" or a low level that may characterize data "0" according to whether a voltage of the initial read signal exceeds the set voltage threshold, so as to realize data reading.

It should be added that in some embodiments, with further reference to FIG. 6, if the charge on the bit line is transferred, after the sense amplifier outputs the data read signal, the data reading method further includes a step S400.

In S400, a recovery write operation is performed on the one-transistor one-capacitor memory cell to recover the read data in the one-transistor one-capacitor memory cell.

It may be understood that if the charge on the bit line is transferred, it indicates that the data previously written in the one-transistor one-capacitor memory cell has been lost in the reading process. In the embodiment of the present disclosure, the recovery write operation is performed on the one-transistor one-capacitor memory cell, which facilitates realizing of repeated reading of the stored data.

In other embodiments, referring to FIG. 7, the storage device is a FRAM, for example. The memory cell U is a one-transistor one-ferroelectric capacitor (1T1C) memory cell U2, which includes a transistor T and a first ferroelectric capacitor C1. A first source/drain S/D1 of the transistor T is connected with the bit line BL, a second source/drain S/D2 of the transistor T is connected with a first electrode 31 of the first ferroelectric capacitor C1, and a second electrode 32 of the first ferroelectric capacitor C1 is grounded. The storage device further includes a word line WL connected with a gate G of the transistor T.

Here, one of the first source/drain S/D1 and the second source/drain S/D2 of the transistor T may be a source and the other of the first source/drain S/D1 and the second source/drain S/D2 of the transistor T may be a drain according to a current transmission direction. A dielectric layer 33 between the first electrode 31 and the second electrode 32 in the first ferroelectric capacitor C1 is of a ferroelectric material, which includes but is not limited to hafnium zirconium oxide (HfZrO, also known as HZO, which contains hafnium, zirconium and oxygen), silicon-doped (Si-doped) hafnium oxide (which is a material containing hafnium, oxygen and silicon), germanium-doped (Ge-doped) hafnium oxide (which is a material containing hafnium, oxygen and germanium), aluminum-doped (Al-doped) hafnium oxide (which is a material containing hafnium, oxygen and aluminum), yttrium-doped (Y-doped) hafnium oxide (which is a material containing hafnium, oxygen and yttrium), lead zirconate titanate (which is a material containing hafnium, including lead, zirconium and titanium), barium zirconate titanate (which is a material containing barium, zirconium and titanium), and combinations thereof.

Moreover, when the data "1" or the data "0" is written in the one-transistor one-ferroelectric capacitor (1T1C) memory cell U2 described above, a ferroelectric material in the first ferroelectric capacitor C1 may correspondingly present different polarization states: for example, when the data "1" is written, the ferroelectric material in the first ferroelectric capacitor C1 is in a first polarization state; and for example, when the data "0" is written, the ferroelectric material in the first ferroelectric capacitor C1 is in a second polarization state. The first polarization state of the ferroelectric material may be reversed to be the second polarization state under action of an external electric field, and the second polarization state of the ferroelectric material may be reversed to be the first polarization state under action of the external electric field, and the second polarization state is, for example, an initial polarization state of the ferroelectric material.

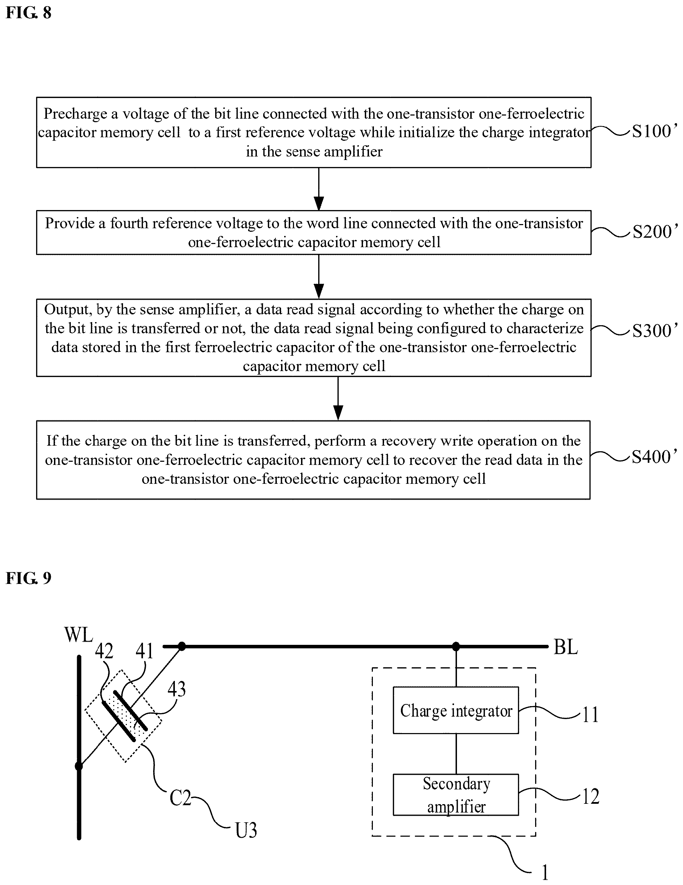

From the above, in some embodiments, referring to FIG. 8, the data reading method of the storage device shown in FIG. 7 may include following steps S100' to S300'.

In S100', a voltage of the bit line connected with the one-transistor one-ferroelectric capacitor memory cell is precharged to a first reference voltage while the charge integrator in the sense amplifier is initialized.

In S200', a fourth reference voltage is provided to a word line connected with the one-transistor one-ferroelectric capacitor memory cell.

In S300', the sense amplifier outputs a data read signal according to whether charge on the bit line is transferred or not, the data read signal is configured to characterize data stored in the first ferroelectric capacitor of the one-transistor one-ferroelectric capacitor memory cell.

For example, the first reference voltage may be a highest voltage in a pre-charge voltage range of the bit line.

For example, the fourth reference voltage may control the transistor T in the one-transistor one-ferroelectric capacitor memory cell U2 to turn on. At this time, charge change may be generated at the first electrode 21 of the first ferroelectric capacitor C1 in either of the first polarization state or the second polarization state, and this changed charge may be transferred to the charge integrator 11 through the turned-on transistor T and the bit line BL, that is, the charge integrator 11 senses whether the charge on the bit line BL has been transferred, and outputs a corresponding voltage signal as an initial read signal. Afterwards, the secondary amplifier 12 in the sense amplifier 1 may output the data read signal according to the comparison result of the initial read signal and the reference signal by comparing the initial read signal with the reference signal. The reference signal is a voltage threshold, for example. The secondary amplifier 12 may convert the initial read signal into a high level that may characterize data "1" or a low level that may characterize data "0" according to whether a voltage of the initial read signal exceeds a set voltage threshold, so as to realize the data reading.

It should be added that in some embodiments, with further reference to FIG. 8, if the charge on the bit line is transferred, after the sense amplifier outputs the data read signal, the data reading method further includes a step S400'.

In S400', a recovery write operation is performed on the one-transistor one-ferroelectric capacitor memory cell to recover the read data in the one-transistor one-ferroelectric capacitor memory cell.

It may be understood that if the charge on the bit line is transferred, it indicates that the data previously written in the one-transistor one-ferroelectric capacitor memory cell has been lost in the reading process. In the embodiment of the present disclosure, the recovery write operation is performed on the one-transistor one-ferroelectric capacitor memory cell, which facilitates realizing of repeated reading of the stored data.

In still other embodiments, referring to FIG. 9, the storage device is a FRAM, for example. The memory cell U is a zero-transistor one-ferroelectric capacitor (0T1C) memory cell U3, which includes a second ferroelectric capacitor C2. A first electrode 41 of the second ferroelectric capacitor C2 is connected to the bit line BL, for example via a gate transistor. The storage device further includes a word line WL connected to a second electrode 42 of the second ferroelectric capacitor C2.

For example, a dielectric layer 43 between the first electrode 41 and the second electrode 42 in the second ferroelectric capacitor C2 is of a ferroelectric material, which includes but is not limited to hafnium zirconium oxide (HfZrO, also known as HZO, which contains hafnium, zirconium and oxygen), silicon-doped (Si-doped) hafnium oxide (which is a material containing hafnium, oxygen and silicon), germanium-doped (Ge-doped) hafnium oxide (which is a material containing hafnium, oxygen and germanium), aluminum-doped (Al-doped) hafnium oxide (which is a material containing hafnium, oxygen and aluminum), yttrium-doped (Y-doped) hafnium oxide (which is a material containing hafnium, oxygen and yttrium), lead zirconate titanate (which is a material containing hafnium , including lead, zirconium and titanium), barium zirconate titanate (which is a material containing barium, zirconium and titanium), and combinations thereof.

Moreover, when the data "1" or the data "0" is written in the zero-transistor one-ferroelectric capacitor (0T1C) memory cell U3, a ferroelectric material in the second ferroelectric capacitor C2 may correspondingly present different polarization states: for example, when the data "1" is written, the ferroelectric material in the second ferroelectric capacitor C2 is in a first polarization state; and for example, when the data "0" is written, the ferroelectric material in the second ferroelectric capacitor C2 is in a second polarization state. The first polarization state of the ferroelectric material may be reversed to be the second polarization state under action of an external electric field, and the second polarization state of the ferroelectric material may be reversed to be the first polarization state under action of the external electric field, and the second polarization state is, for example, an initial polarization state of the ferroelectric material.

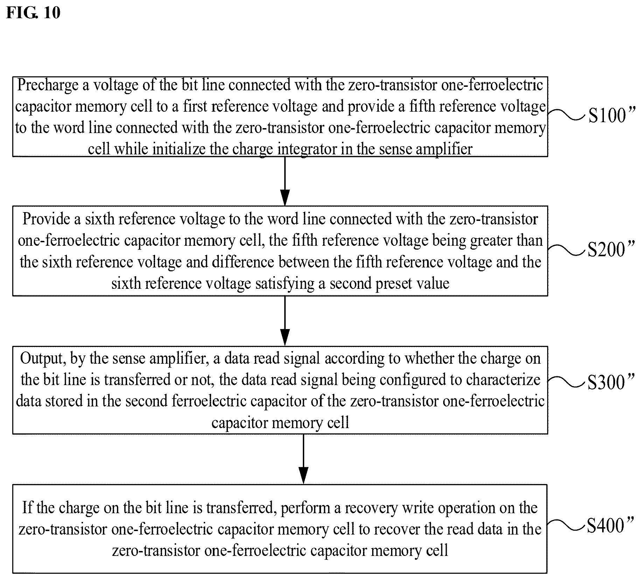

From the above, in some embodiments, referring to FIG. 10, the data reading method of the storage device shown in FIG. 9 may include following steps S100" to S300".

In S100", a voltage of the bit line connected with the zero-transistor one-ferroelectric capacitor memory cell is precharged to a first reference voltage and a fifth reference voltage is provided to a word line connected with the zero-transistor one-ferroelectric capacitor memory cell while the charge integrator in the sense amplifier is initialized.

In S200", a sixth reference voltage is provided to the word line connected with the zero-transistor one-ferroelectric capacitor memory cell, and the fifth reference voltage is greater than the sixth reference voltage, and difference between the fifth reference voltage and the sixth reference voltage satisfies a second preset value.

In S300", the sense amplifier outputs a data read signal according to whether charge on the bit line is transferred or not, the data read signal is configured to characterize data stored in the second ferroelectric capacitor of the zero-transistor one-ferroelectric capacitor memory cell.

It may be understood that the first reference voltage, the fifth reference voltage and the sixth reference voltage described above may all be set according to requirements.

For example, the first reference voltage may be a highest voltage in a pre-charge voltage range of the bit line.

For example, the fifth reference voltage may be a highest voltage in a configurable voltage range of the word line, and the sixth reference voltage may be a lowest voltage in the configurable voltage range of the word line.

In the embodiment of the present disclosure, after the voltage of the word line is lowered from the fifth reference voltage to the sixth reference voltage, charge change may be generated at the first electrode 41 of the second ferroelectric capacitor C2 in either of the first polarization state or the second polarization state, and the charge integrator 11 connected with the bit line BL may sense whether the charge on the bit line BL has been transferred, and output a corresponding voltage signal as an initial read signal. Afterwards, the secondary amplifier 12 in the sense amplifier 1 may output the data read signal according to the comparison result of the initial read signal and the reference signal by comparing the initial read signal with the reference signal. The reference signal is a voltage threshold, for example. The secondary amplifier 12 may convert the initial read signal into a high level that may characterize data "1" or a low level that may characterize data "0" according to whether a voltage of the initial read signal exceeds a set voltage threshold, so as to realize data reading.

It should be added that in some embodiments, with further reference to FIG. 10, if the charge on the bit line is transferred, after the sense amplifier outputs the data read signal, the data reading method further includes a step S400".

In S400", a recovery write operation is performed on the zero-transistor one-ferroelectric capacitor memory cell to recover the read data in the zero-transistor one-ferroelectric capacitor memory cell.

It may be understood that if the charge on the bit line is transferred, it indicates that the data previously written in the zero-transistor one-ferroelectric capacitor memory cell has been lost in the reading process. In the embodiment of the present disclosure, the recovery write operation is performed on the zero-transistor one-ferroelectric capacitor memory cell, which facilitates realizing of repeated reading of the stored data.

An electronic device is further provided in some embodiments of the present disclosure, such as a data storage device, a photocopier, a network device, a household appliance, instrument, a mobile phone, a computer and other devices with data storage functions. The electronic device may include the storage device in some embodiments described above. Other necessary elements or components may also be included in the electronic device, which is not limited by the embodiments of the present disclosure.

The technical features of the above-mentioned embodiments may be combined in an arbitrary manner. For simplicity of description, not all of the possible combinations of the technical features in the embodiments described above are described, however, as long as there is no contradiction between these combinations of the technical features, the combinations should be considered as falling within the scope of this specification.

The above-mentioned embodiments only represent several embodiments of this disclosure, and their descriptions are specific and detailed, but they should not be understood as limiting the scope of this disclosure as such. It should be noted that, several modifications and improvements may be made by those of ordinary skill in the art without departing from the concept of the present disclosure, which belong to the protection scope of the present disclosure. Therefore, the protection scope of this disclosure shall be subjected to appended claims.

## Claims

1. A sense amplifier configured to be connected with a bit line to read data stored in a memory cell, comprising:
a charge integrator correspondingly connected with the memory cell through the bit line, configured to measure a total amount of charge flowing into or out of the bit line at a stable bit line voltage, and convert the total amount of charge into a voltage as an initial read signal; and
a secondary amplifier connected with an output terminal of the charge integrator, configured to compare the initial read signal with a reference signal to output a data read signal according to a comparison result of the initial read signal and the reference signal.

2. The sense amplifier according to claim 1, further comprising:
a pre-charge circuit, configured to be connected with the charge integrator to precharge the charge integrator at an initialization stage, and to be disconnected from the charge integrator at a data reading stage,
wherein the bit line is precharged to a first reference voltage or a second reference voltage at the initialization stage.

3. The sense amplifier according to claim 1 or 2, wherein the charge integrator comprises:
an operational amplifier having a first input terminal, a second input terminal and an output terminal, wherein the first input terminal is configured to receive a first preset voltage, the second input terminal is connected with the bit line and is configured to be precharged to a second preset voltage and receive the charge transferred from the bit line at the data reading stage, and the output terminal is configured to output the initial read signal at the data reading stage; and
a feedback capacitor having a first electrode and a second electrode, wherein the first electrode of the feedback capacitor is connected with the second input terminal of the operational amplifier, and the second electrode of the feedback capacitor is connected with the output terminal of the operational amplifier.

4. The sense amplifier according to claim 3, wherein the reference signal is a voltage threshold; and/or
the second preset voltage is equal to the first preset voltage.

5. The sense amplifier according to any one of claims 1 to 4, wherein the secondary amplifier comprises a latch amplifier.

6. A sensing method of a sense amplifier, comprising:
at a data reading stage,
measuring a total amount of charge flowing into or out of a bit line at a stable bit line voltage and converting the total amount of charge into a voltage as an initial read signal by a charge integrator; and
comparing the initial read signal with a reference signal and outputting a data read signal according to a comparison result of the initial read signal and the reference signal by a secondary amplifier;
wherein the charge integrator is correspondingly connected with a memory cell through the bit line, and the data read signal is configured to characterize data stored in the memory cell.

7. The sensing method of the sense amplifier according to claim 6, further comprising:
at an initialization stage,
precharging the bit line while initializing the charge integrator;
wherein the initialization stage is performed before the data reading stage.

8. The sensing method of the sense amplifier according to claim 6, wherein at the data reading stage, before measuring the total amount of charge flowing into or out of the bit line at the stable bit line voltage and converting the total amount of charge into the voltage as the initial read signal by the charge integrator, the sensing method of the sense amplifier further comprises: disconnecting a pre-charge circuit from the charge integrator.

9. A storage device, comprising:
a memory cell configured to store data;
a bit line connected with the memory cell; and
the sense amplifier according to any one of claims 1 to 5, connected to the bit line and configured to read data stored in the memory cell through the bit line.

10. The storage device according to claim 9, further comprising:
a gate transistor connected with the bit line and the charge integrator in the sense amplifier, and configured to control the bit line to be electrically connected with the charge integrator in the sense amplifier at the data reading stage in response to a column scanning signal for charge transfer.

11. The storage device according to claim 9 or 10, wherein the memory cell comprises a transistor and a capacitor;
wherein a first source/drain of the transistor is connected with the bit line, a second source/drain of the transistor is connected with a first electrode of the capacitor, and a second electrode of the capacitor is grounded; and
the storage device further comprises a word line connected with a gate of the transistor.

12. The storage device according to claim 9 or 10, wherein the memory cell comprises a transistor and a first ferroelectric capacitor;
wherein a first source/drain of the transistor is connected with the bit line, a second source/drain of the transistor is connected with a first electrode of the first ferroelectric capacitor, and a second electrode of the first ferroelectric capacitor is grounded; and
the storage device further comprises a word line connected with a gate of the transistor.

13. The storage device according to claim 9 or 10, wherein the memory cell comprises a second ferroelectric capacitor;
wherein a first electrode of the second ferroelectric capacitor is connected with the bit line; and
the storage device further comprises a word line connected with a second electrode of the second ferroelectric capacitor.

14. A data reading method of the storage device according to claim 11, comprising:
precharging a voltage of the bit line connected with the memory cell to a first reference voltage or a second reference voltage, while initializing the charge integrator in the sense amplifier, wherein the first reference voltage is greater than the second reference voltage and difference between the first reference voltage and the second reference voltage satisfies a first preset value;
providing a third reference voltage to the word line connected with the memory cell; and
outputting, by the sense amplifier, a data read signal according to whether charge on the bit line is transferred or not, the data read signal being configured to characterize data stored in the capacitor of the memory cell.

15. The data reading method of the storage device according to claim 14, wherein the first reference voltage is a highest voltage in a pre-charge voltage range of the bit line, and the second reference voltage is a lowest voltage in the pre-charge voltage range of the bit line.

16. A data reading method of the storage device according to claim 12, comprising:
precharging a voltage of the bit line connected with the memory cell to a first reference voltage while initializing the charge integrator in the sense amplifier;
providing a fourth reference voltage to the word line connected with the memory cell; and
outputting, by the sense amplifier, a data read signal according to whether charge on the bit line is transferred or not, the data read signal being configured to characterize data stored in the first ferroelectric capacitor of the memory cell.

17. A data reading method of the storage device according to claim 13, comprising:
precharging a voltage of the bit line connected with the memory cell to a first reference voltage and providing a fifth reference voltage to the word line connected with the memory cell, while initializing the charge integrator in the sense amplifier;
providing a sixth reference voltage to the word line connected with the memory cell, wherein the fifth reference voltage is greater than the sixth reference voltage, and difference between the fifth reference voltage and the sixth reference voltage satisfies a second preset value; and
outputting, by the sense amplifier, a data read signal according to whether charge on the bit line is transferred or not, the data read signal being configured to characterize data stored in the second ferroelectric capacitor of the memory cell.

18. The data reading method of the storage device according to claim 17, wherein the first reference voltage is a highest voltage in a pre-charge voltage range of the bit line, the fifth reference voltage is a highest voltage in a configurable voltage range of the word line, and the sixth reference voltage is a lowest voltage in the configurable voltage range of the word line.

19. The data reading method of the storage device according to any one of claims 14 to 18, wherein, if the charge on the bit line is transferred, after the sense amplifier outputs the data read signal, the data reading method further comprises:
performing a recovery write operation on the memory cell to recover the read data in the memory cell.

20. An electronic device, comprising the storage device according to any one of claims 9 to 13.
